# EUROPEAN PATENT APPLICATION

(11) **EP 4 773 754 A1**
(43) Date of publication of application: **08.07.2026**
(21) Application number: 25176899.0
(22) Date of filing: 16.05.2025
(51) Int. Cl.: H10D 30/01, H10D 30/66, H10D 12/01, H10D 64/27

(54) **TRENCH-TYPE POWER SEMICONDUCTOR DEVICE HAVING GATE PROTRUSION STRUCTURES AND PREPARATION METHOD THEREOF**

(30) Priority: 06.01.2025 CN 202510021182
(71) Applicant: Chongqing Alpha and Omega Semiconductor Limited, Chongqing 400700 (CN)
(72) Inventor: YANG, Li, Chongqing, 400700 (CN)
(74) Representative: Metida

(57) **Abstract**

A trench-type power semiconductor device having gate protrusion structures and a preparation method thereof are provided. The preparation method includes depositing at least one epitaxial layer (2) on a silicon substrate (1); preparing a silicon dioxide pad layer (3), a first mask layer (4), and a second mask layer (5) on the at least one epitaxial layer (2); etching to form gate trench trenches; forming a gate oxide layer (8); depositing gate polysilicon (9); removing a first portion of the gate polysilicon (9) on a surface of the first mask layer (4) by chemical mechanical polishing; removing the first mask layer (4) and adjusting a morphology of the gate polysilicon (9) on a silicon platform region; forming body regions (11) and source regions (12) through ion implantation; and preparing source region contact holes (14) and tungsten plugs.

## Description

### TECHNICAL FIELD

The present disclosure relates to a field of power device semiconductors, and in particular to a trench-type power semiconductor device having gate protrusion structures and a preparation method thereof.

### BACKGROUND

Due to attention of social boundaries to environmental protection, a status of power devices in electronic power applications is increasingly significant due to characteristics of power saving and power saving. Power device manufacturers continuously iteratively push new power devices with lower power consumption according to market demands. A method for manufacturing a conventional trench-type gate power device comprises: growing an epitaxial layer on a silicon substrate; forming trenches in the epitaxial layer; forming a gate oxide layer; forming gate polysilicon; manufacturing body regions and source regions; forming a dielectric layer and forming contact holes and tungsten plugs; forming a circuit connection; and finally forming a passivation layer.

However, the above manufacturing method brings following problems. First, since a gate oxide layer of a power device with a low turn-on threshold is thin, chemical mechanical polishing is not allowed to be performed to flatten the gate polysilicon, so dry plasma etching is adopted to process the gate polysilicon. In order to avoid residual ridge polysilicon caused by dry plasma etching, it is commonly necessary to over etch the gate polysilicon, which causes deeper recesses to form on a top of the trench-type gate polysilicon. Sidewalls of the trenches are exposed via the recesses, resulting in a greater impact on trench doping during subsequent ion implantation processes. In addition, reducing the on-resistance requires slightly shortening lengths of the trenches. However, shorter trenches may make the impact of trench doping more serious, causing the trenches to leak electricity and cannot be mass-produced. Secondly, if the gate polysilicon is over etched, the top of the polysilicon is recessed, which increases a gate resistance and affects a turn-on speed and linear current capacity of the power device. Therefore, it is necessary to improve the manufacturing method of the conventional trench-type gate power device.

### SUMMARY

In view of deficiencies in the prior art, a technical problem to be solved by the present disclosure is to provide a trench-type power semiconductor device having gate protrusion structures and a preparation method thereof.

To solve the technical problem, the present disclosure provides a preparation method of a trench-type power semiconductor device having gate protrusion structures. The preparation method comprises:
step S1: depositing at least one epitaxial layer on a silicon substrate;
step S2: sequentially preparing a silicon dioxide pad layer, a first mask layer, and a second mask layer on the at least one epitaxial layer;
step S3: etching a gate trench pattern on the second mask layer, the first mask layer, and the silicon dioxide pad layer, and etching gate trench pattern on the at least one epitaxial layer to form gate trenches;
step S4: forming a gate oxide layer on trench walls of the gate trenches;
step S5: depositing gate polysilicon to fill the gate trenches;
step S6: removing a first portion of the gate polysilicon on a surface of the first mask layer by chemical mechanical polishing;
step S7: removing the first mask layer by wet etching, and adjusting a morphology of a second portion of the gate polysilicon on a silicon platform region by dry etching;
step S8: forming body regions and source regions through ion implantation;
step S9: preparing source region contact holes and tungsten plugs; and
step S10: completing a subsequent preparation process of the trench-type power semiconductor device.

The present disclosure further provides a trench-type power semiconductor device having gate protrusion structures. The trench-type power semiconductor device having the gate protrusion structures is prepared by the preparation method mentioned above.

In the present disclosure, the gate protrusion structures are formed during the preparation process of the trench-type power semiconductor device, which prevent a polysilicon gate etching process window of the trench-type power semiconductor device with short channels from becoming too sensitive to the channels. Therefore, since the gate trenches are not over etched, impurities doped into the source regions by ion implantation are not doped into the sidewalls of the gate trenches formed after polysilicon etching, thereby avoiding a problem of leakage of conductive channels, and enabling the trench-type power semiconductor device with small on-resistance to be mass-produced smoothly. Further, by increasing a cross-sectional area of the gate polysilicon, a gate resistance is reduced, a switching speed and a linear region capability are improved, and performance thereof is optimized.

### BRIEF DESCRIPTION OF DRAWINGS

FIG. 1 is a flow chart of a preparation method of a trench-type power semiconductor device having gate protrusion structures of the present disclosure.
FIG. 2 is a schematic diagram of a structure after forming a hard mask on an epitaxial layer.
FIG. 3 is a schematic diagram of a structure after etching a gate trench pattern on the hard mask.
FIG. 4 is a schematic diagram of a structure after etching the structure shown in FIG. 3 to form gate trenches.
FIG. 5 is a schematic diagram of a structure after removing a second mask layer by etching.
FIG. 6 is a schematic diagram of a structure after growing a sacrificial oxide layer.
FIG. 7 is a schematic diagram of a structure after etching to remove the sacrificial oxide layer.
FIG. 8 is a schematic diagram of a structure after growing a gate oxide layer.
FIG. 9 is a schematic diagram of a structure after depositing gate polysilicon.
FIG. 10 is a schematic diagram of a structure after removing the gate polysilicon on a surface of a first mask layer by chemical mechanical polishing.
FIG. 11 is a schematic diagram of a structure after removing the first mask layer.
FIG. 12 is a schematic diagram of a structure after adjusting morphology of the gate polysilicon on a silicon platform region.
FIG. 13 is a schematic diagram of a structure after implanting first impurities to form body regions.
FIG. 14 is a schematic diagram of a structure after forming source regions and a silicon dioxide dielectric layer.
FIG. 15 is a schematic diagram of a structure after forming source region contact holes.
FIG. 16 is a schematic diagram of a structure after forming an ohmic contact region and thermally annealing to activate third impurities.

### DETAILED DESCRIPTION

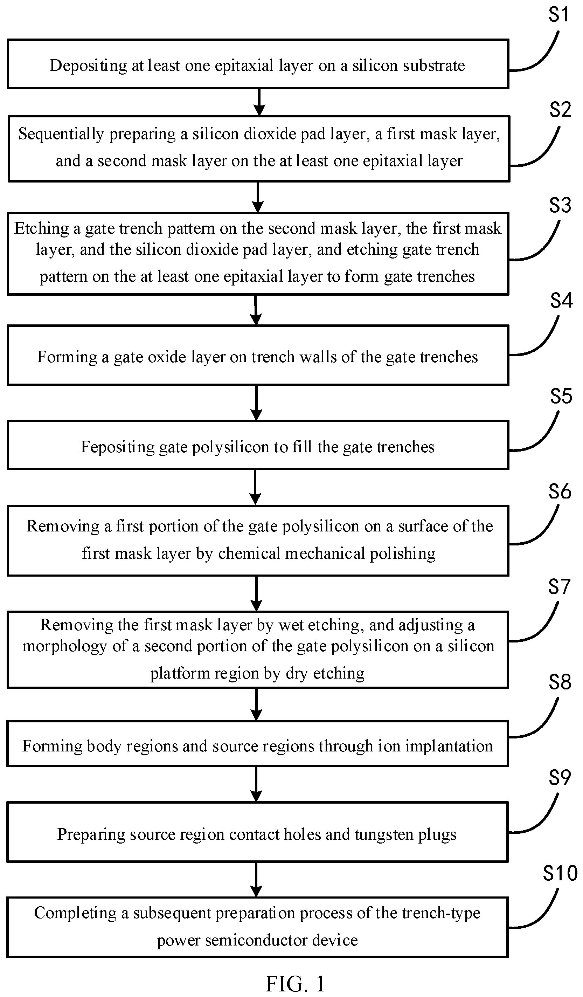

As shown in FIG. 1, FIG. 1 is a flow chart of a preparation method of a trench-type power semiconductor device having gate protrusion structures of the present disclosure.

The preparation method of the trench-type power semiconductor device having gate protrusion structures comprises steps S1-S10.

The step S1 comprises depositing at least one epitaxial layer 2 on a silicon substrate 1. The at least one epitaxial layer 2 is generally grown by chemical vapor deposition. The at least one epitaxial layer 2 is doped with trivalent elements (such as boron) or pentavalent elements (such as arsenic and phosphorus) according to a device polarity. A thickness of an epitaxial layer 2 is determined according to an operating voltage or a multi-layer structure of epitaxial layers 2 is adopted.

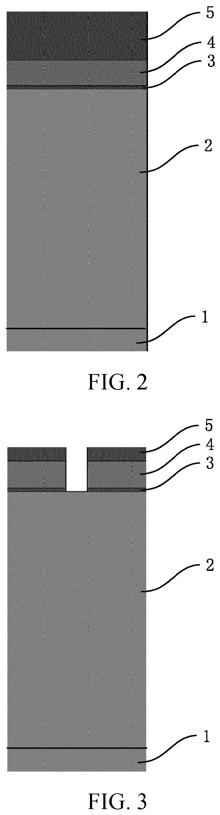

A shown in FIG. 2, the step S2 comprises sequentially preparing a silicon dioxide pad layer 3, a first mask layer 4, and a second mask layer 5 on the at least one epitaxial layer 2. It should be noted that FIGS. 2-16 are schematic diagrams of a relevant region in a cell structure during a preparation process, and are not complete structural schematic diagrams thereof. The silicon dioxide pad layer 3, the first mask layer 4, and the second mask layer 5 are prepared to form a hard mask. In the embodiment, the first mask layer 4 is made from silicon nitride, and the second mask layer 5 is made from silicon dioxide, thereby forming a multilayer composite structure of an insulator mask of silicon dioxide-silicon nitride-silicon dioxide. Both the silicon dioxide and the silicon nitride are prepared by a chemical vapor deposition process.

The step S3 comprises etching a gate trench pattern on the hard mask ( i.e., the second mask layer 5, the first mask layer 4, and the silicon dioxide pad layer 3), and etching gate trench pattern on the at least one epitaxial layer 2 to form gate trenches 6. The step S3 comprises steps S310-S330.

The step S310 comprises coating the second mask layer 5 with a first photoresist, and exposing the gate trench pattern on the first photoresist through a mask to form a photoresist pattern.

As shown in FIGS. 3-4, the step S320 comprises dry etching the second mask layer 5, the first mask layer 4, and the silicon dioxide pad layer 3 through the photoresist pattern to form a mask pattern, and forming the gate trenches 6 by dry etching on the at least one epitaxial layer 2 through the mask pattern. The gate trenches 6 comprise chip functional structures such as cell gate trenches 6 and gate interconnection trenches.

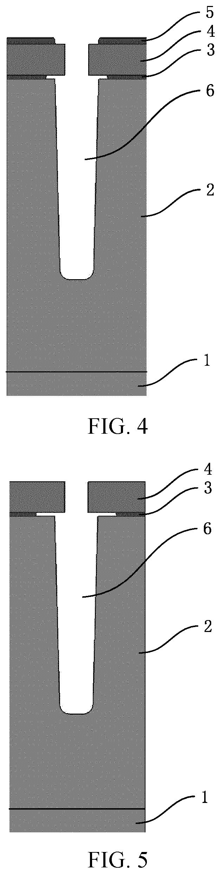

As shown in FIG. 5, the step S330 comprises removing the first photoresist and the second mask layer 5 by wet etching, and performing wet cleaning before growing a sacrificial oxide layer 7. Since the materials of silicon dioxide pad layer 3 and the second mask layer 5 in the embodiment are both silicon dioxide, when the second mask layer 5 is removed by wet etching, part of the second mask layer 5 is removed.

The step S4 comprises forming a gate oxide layer 8 on trench walls of the gate trenches 6. The step S4 comprises steps S410-S430.

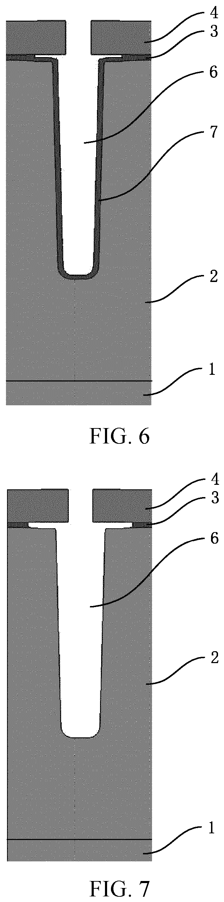

As shown in FIG. 6, the step S410 comprises growing a silicon dioxide layer on the trench walls of the gate trenches 6 as the sacrificial oxide layer 7. A thickness of the sacrificial oxide layer 7 is generally 5- 50 nm. By forming the sacrificial oxide layer 7, the cell gate trenches and the gate interconnection trenches are rounded and plasma damage repaired by using a thermal oxidation process.

As shown in FIG. 7, the step S420 comprises removing the sacrificial oxide layer 7 by wet etching.

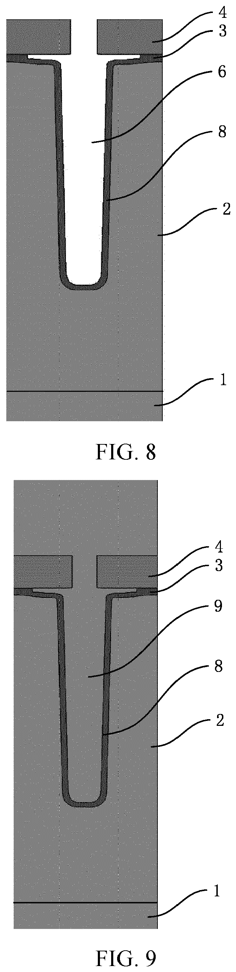

As shown in FIG. 8, the step S430 comprises growing the gate oxide layer 8 on the trench walls of the gate trenches 6 by the thermal oxidation process. A thickness of the gate oxide layer 8 is determined according to requirements of device performance, and the thickness of the gate oxide layer 8 is generally 5-50 nm.

As shown in FIG. 9, the step S5 comprises depositing gate polysilicon 9 to fill the gate trenches 6. A thickness of the gate polysilicon 9 is determined according to actual depths of the gate trenches 6.

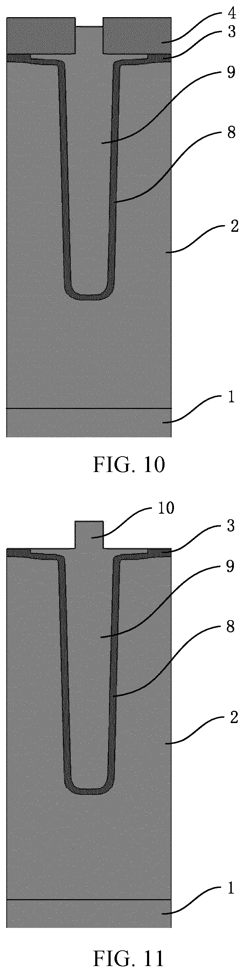

As shown in FIG. 10, the step S6 comprises removing a first portion of the gate polysilicon 9 on a surface of the first mask layer 4 by chemical mechanical polishing. Since a stop position is unable to be set accurately during chemical mechanical polishing, in the actual process, after polishing to the surface of the first mask layer 4, a further portion of the first mask layer 4 is polished downward.

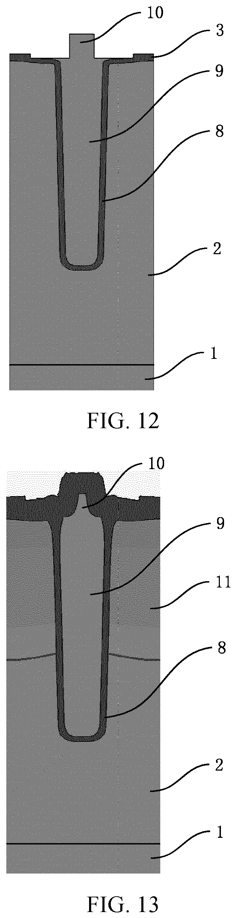

As shown in FIGS. 11 and 12, the step S7 comprises removing the first mask layer 4 by wet etching, and adjusting a morphology of a second portion of the gate polysilicon 9 on a silicon platform region by dry etching. After removing the first mask layer 4, protruding gate polysilicon structures, i.e., the gate protrusion structures 10 , remains on the surfaces of the gate trenches 6. A main purpose of adjusting the morphology of the second portion of the gate polysilicon 9 is to remove the gate polysilicon 9 extending laterally from the gate trenches 6 to the silicon platform region to avoid affecting subsequent ion implantation and adjust the gate resistance. Of course, it is not necessary to remove all the gate polysilicon 9 extending laterally from the gate trenches 6 to the silicon platform region, and a small amount of gate polysilicon 9 may be left in regions on the silicon platform region that does not affect the ion implantation of the body regions 11.

The step S8 comprises forming body regions and source regions 12 through ion implantation. The step S8 comprises steps S810-S850.

As shown in FIG. 13, the step S810 comprises implanting first impurities into an upper surface of the at least one epitaxial layer 2 to form the body regions 11. The first impurities are the trivalent element or the pentavalent element, and a specific type thereof is determined according to a polarity of the trench-type power semiconductor device.

The step S820 comprises activating the first impurities in the body regions 11 by a thermal process. At this time, a surface of exposed gate polysilicon 9 is oxidized to form the silicon dioxide. Therefore, the small amount of the gate polysilicon 9 remaining on the silicon platform region in the step S7 is oxidized to form the silicon dioxide.

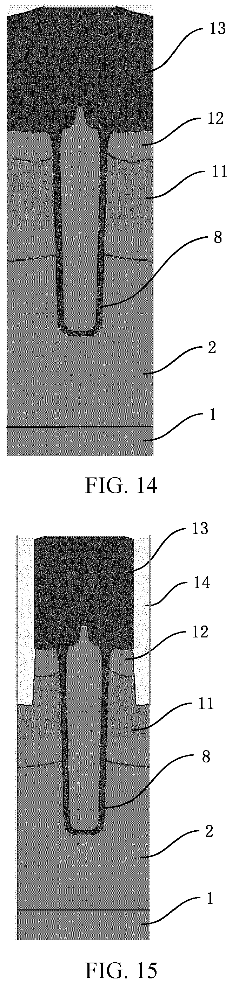

As shown in FIG. 14, the step S830 comprises forming the source regions 12 on upper surfaces of the body regions 11 by implanting second impurities. The second impurity implanted by the ion implantation may be the pentavalent element or the trivalent element. The second impurities implanted into the source regions 12 have a polarity opposite to that of the first impurities. That is, when the first impurities implanted into the body regions 11 are the trivalent element, the second impurities implanted into the source regions 12 is the pentavalent element. Alternatively, when the first impurities implanted into the body regions 11 are the pentavalent element, the second impurities implanted into the source regions 12 are the trivalent element.

The step S840 comprises activating the second impurities in the source regions 12 by the thermal process to obtain cell structures.

As shown in FIG. 14, the step S850 comprises forming a silicon dioxide dielectric layer 13 on the cell structures by the chemical vapor deposition.

The step S9 comprises preparing source region contact holes 14 and tungsten plugs. The step S9 comprises S910-S950.

As shown in FIG. 15, the step S910 comprises defining a source region contact hole pattern by a second photoresist, and dry etching the silicon dioxide dielectric layer 13 and the at least one epitaxial layer 2 to form source region contact holes 14.

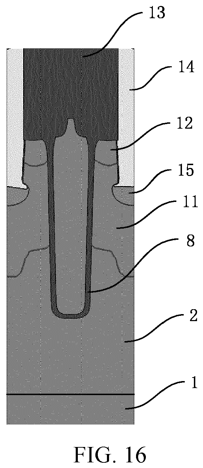

As shown in FIG. 16, the step S920 comprises forming ohmic contact regions 15 respectively at bottom portions of the source region contact holes 14 by doping third impurities of a high concentration to the bottom portions of the source region contact holes 14. A polarity of the third impurities implanted in the step is opposite to the polarity of the second impurities implanted into the source regions 12.

As shown in FIG. 16, the step S930 comprises activating the third impurities by rapid thermal annealing.

The step S940 comprises depositing metal tungsten (not shown) in the source region contact holes 14 through a tungsten plug process. Before depositing the metal tungsten, metal and nitride are deposited by physical vapor deposition as protective layers for the source region contact holes 14. Then, rapid thermal annealing is performed to form silicide, and the metal may be one or more of titanium, cobalt, and tantalum.

The step S950 comprises removing portions of the metal tungsten outside the source region contact holes 14 by dry etching, and forming the tungsten plugs respectively disposed in the contact source region contact holes 14.

The step S10 comprises completing a subsequent preparation process of the trench-type power semiconductor device. The subsequent preparation process of the trench-type power semiconductor device generally comprises: depositing an aluminum-copper compound on the tungsten plugs by physical vapor deposition; forming a circuit by using a photolithography process and a dry etching process; depositing a passivation layer and etching the passivation layer by a photolithography process, where the passivation layer generally comprises the silicon nitride or the silicon dioxide for alloy annealing, etc. The subsequent preparation process after the tungsten plug is formed is the prior art, and details are not described herein. After the subsequent preparation process is completed, the trench-type power semiconductor device with the gate protrusion structures 10 is obtained.

In the present disclosure, the gate protrusion structures 10 are formed during the preparation process of the trench-type power semiconductor device, which prevent a polysilicon gate etching process window of the trench-type power semiconductor device with short channels from becoming too sensitive to the trenches. Therefore, since the gate trenches 6 are not over etched, impurities doped into the source regions 12 by ion implantation are not doped into the sidewalls of the gate trenches formed after polysilicon etching and do not affect channels, thereby avoiding a problem of leakage of conductive channels, and enabling the trench-type power semiconductor device with small on-resistance to be mass-produced smoothly. Further, by increasing a cross-sectional area of the gate polysilicon, a gate resistance is reduced, a switching speed and a linear region capability are improved, and performance thereof is optimized.

The present disclosure further provides a trench-type power semiconductor device having gate protrusion structures. The trench-type power semiconductor device having the gate protrusion structures is prepared by the preparation method mentioned above.

## Claims

1. A preparation method of a trench-type power semiconductor device having gate protrusion structures, comprising:
step S1: depositing at least one epitaxial layer (2) on a silicon substrate (1);
step S2: sequentially preparing a silicon dioxide pad layer (3), a first mask layer (4), and a second mask layer (5) on the at least one epitaxial layer (2);
step S3: etching a gate trench pattern on the second mask layer (5), the first mask layer (4), and the silicon dioxide pad layer (3), and etching gate trench pattern on the at least one epitaxial layer (2) to form gate trenches (6);
step S4: forming a gate oxide layer (8) on trench walls of the gate trenches (6);
step S5: depositing gate polysilicon (9) to fill the gate trenches (6);
step S6: removing a first portion of the gate polysilicon (9) on a surface of the first mask layer (4) by chemical mechanical polishing;
step S7: removing the first mask layer (4) by wet etching, and adjusting a morphology of a second portion of the gate polysilicon (9) on a silicon platform region by dry etching;
step S8: forming body regions (11) and source regions (12) through ion implantation;
step S9: preparing source region contact holes (14) and tungsten plugs; and
step S 10: completing a subsequent preparation process of the trench-type power semiconductor device.

2. The preparation method according to claim 1, wherein the at least one epitaxial layer (2) is formed by chemical vapor deposition, and the at least one epitaxial layer (2) is doped with a trivalent element or a pentavalent element.

3. The preparation method according to claim 1, wherein a material of the first mask layer (4) is silicon nitride, and a material of the second mask layer (5) is silicon dioxide.

4. The preparation method according to any one of claims 1-3, wherein the step S3 comprises:
step S310: coating the second mask layer (5) with a first photoresist, and exposing the gate trench pattern on the first photoresist through a mask to form a photoresist pattern;
step S320: dry etching the second mask layer (5), the first mask layer (4), and the silicon dioxide pad layer (3) through the photoresist pattern to form a mask pattern, and forming the gate trenches (6) by dry etching on the at least one epitaxial layer (2) through the mask pattern; and
step S330: removing the first photoresist and the second mask layer (5) by wet etching, and performing wet cleaning.

5. The preparation method according to claim 4, wherein the gate trenches (6) comprise cell gate trenches (6) and gate interconnect trenches.

6. The preparation method according to claim 4, wherein the step S4 comprises:
step S410: growing a silicon dioxide layer on the trench walls of the gate trenches (6) as a sacrificial oxide layer (7);
step S420: removing the sacrificial oxide layer (7) by wet etching; and
step S430: growing the gate oxide layer (8) on the trench walls of the gate trenches (6) by a thermal oxidation process.

7. The preparation method according to claim 6, wherein a thickness of the sacrificial oxide layer (7) is 5-50 nm, and a thickness of the gate oxide layer (8) is 5-50 nm.

8. The preparation method according to claim 6, wherein the step S8 comprises:
step S810: implanting first impurities into an upper surface of the at least one epitaxial layer (2) to form the body regions (11);
step S820: activating the first impurities in the body regions (11) by a thermal process;
step S830: forming the source regions (12) on upper surfaces of the body regions (11) by implanting second impurities
step S840: activating the second impurities in the source regions (12) by the thermal process to obtain cell structures; and
step S850: forming a silicon dioxide dielectric layer (13) on the cell structures by the chemical vapor deposition.

9. The preparation method according to claim 8, wherein the step S9 comprises:
step S910: defining a source region contact hole pattern by a second photoresist, and dry etching the silicon dioxide dielectric layer (13) and the at least one epitaxial layer (2) to form source region contact holes (14);
step S920: forming ohmic contact regions (15) respectively at bottom portions of the source region contact holes (14) by doping third impurities of a high concentration to the bottom portions of the source region contact holes (14);
step S930: activating the third impurities by rapid thermal annealing;
step S940: depositing metal tungsten in the source region contact holes (14) through a tungsten plug process; and
step S950: removing portions of the metal tungsten outside the source region contact holes (14) by dry etching, and forming the tungsten plugs respectively disposed in the contact source region contact holes (14).

10. A trench-type power semiconductor device having gate protrusion structures, wherein the trench-type power semiconductor device is manufactured by the preparation method according to any one of claims 1-9.

## Amended claims

### Amended claims in accordance with Rule 137(2) EPC.

1. A preparation method of a trench-type power semiconductor device having gate protrusion structures, comprising:
step S1: depositing at least one epitaxial layer (2) on a silicon substrate (1);
step S2: sequentially preparing a silicon dioxide pad layer (3), a first mask layer (4), and a second mask layer (5) on the at least one epitaxial layer (2);
step S3: etching a gate trench pattern on the second mask layer (5), the first mask layer (4), and the silicon dioxide pad layer (3), and etching gate trench pattern on the at least one epitaxial layer (2) to form gate trenches (6);
step S4: forming a gate oxide layer (8) on trench walls of the gate trenches (6);
step S5: depositing gate polysilicon (9) to fill the gate trenches (6);
step S6: removing a first portion of the gate polysilicon (9) on a surface of the first mask layer (4) by chemical mechanical polishing;
step S7: removing the first mask layer (4) by wet etching, and adjusting a morphology of a second portion of the gate polysilicon (9) on a silicon platform region by dry etching;
step S8: forming body regions (11) and source regions (12) through ion implantation;
step S9: preparing source region contact holes (14) and tungsten plugs; and
step S10: completing a subsequent preparation process of the trench-type power semiconductor device.

2. The preparation method according to claim 1, wherein the at least one epitaxial layer (2) is formed by chemical vapor deposition, and the at least one epitaxial layer (2) is doped with a trivalent element or a pentavalent element.

3. The preparation method according to claim 1, wherein a material of the first mask layer (4) is silicon nitride, and a material of the second mask layer (5) is silicon dioxide.

4. The preparation method according to any one of claims 1-3, wherein the step S3 comprises:
step S310: coating the second mask layer (5) with a first photoresist, and exposing the gate trench pattern on the first photoresist through a mask to form a photoresist pattern;
step S320: dry etching the second mask layer (5), the first mask layer (4), and the silicon dioxide pad layer (3) through the photoresist pattern to form a mask pattern, and forming the gate trenches (6) by dry etching on the at least one epitaxial layer (2) through the mask pattern; and
step S330: removing the first photoresist and the second mask layer (5) by wet etching, and performing wet cleaning.

5. The preparation method according to claim 4, wherein the gate trenches (6) comprise cell gate trenches (6) and gate interconnect trenches.

6. The preparation method according to claim 4, wherein the step S4 comprises:
step S410: growing a silicon dioxide layer on the trench walls of the gate trenches (6) as a sacrificial oxide layer (7);
step S420: removing the sacrificial oxide layer (7) by wet etching; and
step S430: growing the gate oxide layer (8) on the trench walls of the gate trenches (6) by a thermal oxidation process.

7. The preparation method according to claim 6, wherein a thickness of the sacrificial oxide layer (7) is 5-50 nm, and a thickness of the gate oxide layer (8) is 5-50 nm.

8. The preparation method according to claim 6, wherein the step S8 comprises:
step S810: implanting first impurities into an upper surface of the at least one epitaxial layer (2) to form the body regions (11);
step S820: activating the first impurities in the body regions (11) by a thermal process;
step S830: forming the source regions (12) on upper surfaces of the body regions (11) by implanting second impurities
step S840: activating the second impurities in the source regions (12) by the thermal process to obtain cell structures; and
step S850: forming a silicon dioxide dielectric layer (13) on the cell structures by the chemical vapor deposition.

9. The preparation method according to claim 8, wherein the step S9 comprises:
step S910: defining a source region contact hole pattern by a second photoresist, and dry etching the silicon dioxide dielectric layer (13) and the at least one epitaxial layer (2) to form source region contact holes (14);
step S920: forming ohmic contact regions (15) respectively at bottom portions of the source region contact holes (14) by doping third impurities of a high concentration to the bottom portions of the source region contact holes (14);
step S930: activating the third impurities by rapid thermal annealing;
step S940: depositing metal tungsten in the source region contact holes (14) through a tungsten plug process; and
step S950: removing portions of the metal tungsten outside the source region contact holes (14) by dry etching, and forming the tungsten plugs respectively disposed in the contact source region contact holes (14).
